# EUROPÄISCHE PATENTANMELDUNG

(11) **EP 4 379 404 A1**
(43) Veröffentlichungstag der Anmeldung: **05.06.2024**
(21) Anmeldenummer: 23211984.2
(22) Anmeldetag: 24.11.2023
(51) Int. Cl.: G01R 31/34

(54) **VORRICHTUNG UND VERFAHREN ZUR DETEKTION VON FEHLERZUSTÄNDEN IN EINER ELEKTRISCHEN MASCHINE**

(30) Priorität: 02.12.2022 DE 102022132023
(71) Anmelder: ebm-papst Mulfingen GmbH & Co. KG, 74673 Mulfingen (DE)
(72) Erfinder: SCHROTH, Sebastian, 74635 Kupferzell (DE)
(74) Vertreter: Otten, Roth, Dobler & Partner mbB Patentanwälte

(57) **Zusammenfassung**

Vorrichtung zur Detektion von Fehlerzuständen in einer elektrischen Maschine mit einem Rotor und einem zu dem Rotor elektrisch isoliert aufgebauten Stator, umfassend eine Anschlusselektronik zum Anschluss der elektrischen Maschine, wobei entweder der Stator mittels einer elektrischen Verbindung an einem gegenüber dem Erdpotential stabilen ersten elektrischen Potential der Anschlusselektronik verbunden ist, oder der Stator direkt mit einem, gegenüber dem Erdpotential, stabilen zweiten elektrischen Potential verbunden ist und das zweite elektrische Potential mittels der elektrischen Verbindung mit der Anschlusselektronik verbunden ist, wobei ein erster Sensor zur Messung eines ersten Phasenstroms, sowie ein zweiter Sensor zur Messung eines zweiten Phasenstroms, sowie ein dritter Sensor zur Messung eines elektrischen Signals des Stators über und/oder an der elektrischen Verbindung ausgebildet ist.

## Beschreibung

Um ökologisch nachhaltige Möglichkeiten in der Fertigung von Elektromotoren gleich welcher Art zu schaffen, kann das Beschreiben und Vorhersagen von Lebenszyklen solcher Maschinen ein Schlüsselfaktor sein. Wichtig ist hierbei, dass zustandsorientierte Wartungssysteme eingesetzt werden, die mittels Datenanalyseverfahren, wie beispielsweise der Erkennung von Fehlern, Defekten oder Anomalien, Aussagen über den Zustand der elektrischen Maschine liefern können.

In der Regel werden hierbei Techniken des maschinellen Lernens eingesetzt und sogenannte Klassifikatoren zur Erkennung von Anomalien bestimmt, die beispielsweise auf Fehler oder Defekten in Lagern von Motoren anhand von Spezifikationen (z.B. Kennlinien) der Lager schließen lassen. Maschinelles wie auch überwachtes Lernen erfordern hierbei große Datenmengen die im Moment des fehlerhaften Zustands oder des defekten Zustands oder des anormalen Betriebs der elektrischen Maschine vorliegen müssen. Die Generierung dieser Datenmengen benötigt jedoch Zeit.

Aus dem Stand der Technik sind Datenanalyseverfahren zur Erkennung von Motorlagerausfällen anhand von Daten im Normalbetrieb bekannt. Bei derartigen Verfahren wird beispielsweise ein Leistungsspektrum aus aktuellen Sensorsignalen erstellt, mit welchem der Normalzustand eines Motorlagers ermittelt werden kann. Anschließend lassen sich Wahrscheinlichkeiten berechnen, wann Abweichungen vom Normalzustand vorliegen. Hierdurch kann beispielsweise auf eine unzureichende Schmierung z.B. durch fehlendes Fett im Lager einer elektrischen Maschine geschlossen werden.

Aus dem Stand der Technik ist weiterhin bekannt, dass mit Hilfe von Maschinenströmen in einer elektrischen Maschine Isolationsfehler oder Isolationsdefekte oder Lagerschäden erkannt werden können. In der Regel werden derartige elektrische Maschinen mit einer festen Verbindung zum Erdpotential betrieben. Treten Fehlerströme auf Grund eines Wicklungsdefekts auf, sind dies Gleichtaktströme und weisen eine im Gegensatz zu den Maschinenströmen höhere Frequenz auf.

Weiterhin ist aus dem Dokument EP 3 326 285 B1 eine Vorrichtung zur Reduzierung und/oder zur Vermeidung von schädlichen Lagerströmen in einer elektrischen Maschine mit einem Rotor und einem isoliert aufgebauten Stator bekannt, wobei der Stator durch eine elektrische Verbindung mit einem hochfrequenten, gegenüber dem Erdpotential verschiedenen und gegenüber diesem stabilen Elektronikpotential an einem Potentialabgriff der Anschlusselektronik verbunden ist.

Somit ist auch aus dem Stand der Technik bekannt, dass mittels eines isolierten Stators Einfluss auf Lagerspannungen genommen werden kann.

Nachteilig ist hierbei, dass allein auf Grund der benötigten Datenmenge im Betrieb der elektrischen Maschine nur sehr aufwändig und nicht zeitnah mögliche Defekte erkannt werden können.

Aufgabe der Erfindung ist es daher die Möglichkeiten zur Berechnung einer noch verbleibenden Lebensdauer einer elektrischen Maschine zu verbessern und mögliche Fehler oder Defekte im Betrieb der Maschine besser vorhersagen zu können.

Die technische Aufgabe wird durch einen Gegenstand mit den technischen Merkmalen nach den unabhängigen Ansprüchen gelöst. Vorteilhafte Ausführungsformen sind Gegenstand der abhängigen Ansprüche und der Beschreibung.

Gemäß einem Aspekt wird die technische Aufgabe der Erfindung gelöst durch eine Vorrichtung zur Detektion von Fehlerzuständen in einer elektrischen Maschine mit einem Rotor und einem zu dem Rotor elektrisch isoliert aufgebauten Stator, umfassend eine Anschlusselektronik zum Anschluss der elektrischen Maschine, wobei entweder der Stator mittels einer elektrischen Verbindung an einem gegenüber dem Erdpotential stabilen ersten elektrischen Potential der Anschlusselektronik verbunden ist, oder der Stator direkt mit einem, gegenüber dem Erdpotential, stabilen zweiten elektrischen Potential verbunden ist und das zweite elektrische Potential mittels der elektrischen Verbindung mit der Anschlusselektronik verbunden ist, wobei ein erster Sensor zur Messung eines ersten Phasenstroms, sowie ein zweiter Sensor zur Messung eines zweiten Phasenstroms, sowie ein dritter Sensor zur Messung eines elektrischen Signals des Stators über und/oder an der elektrischen Verbindung ausgebildet ist.

Im Sinne der Erfindung kann unter einem Fehler auch ein Defekt verstanden werden. Eine elektrische Maschine kann beispielsweise als ein elektrischer Motor oder ein dreiphasiger Elektromotor oder ein bürstenloser Gleichstrommotor ausgebildet sein. Die elektrische Verbindung kann beispielsweise als wenigstens ein Kondensator, insbesondere als wenigstens ein Y-Kondensator, ausgebildet sein und eine höherfrequente niedrige Impedanz aufweisen. Im Sinne der Erfindung ist unter höherfrequent ein Frequenzbereich 1 kHz bis 20 kHz zu verstehen. Unter dem elektrischen Signal sind im Sinne der Erfindung beispielsweise ein Strom und/oder ein Potential zu verstehen.

Im Fall des direkt mit dem stabilen zweiten Potentials verbundenen Stators kann eine mechanische Anbindung vorgesehen sein, die beispielsweise mittels Verschraubungen oder mittels Fügen von Statorblechen ausgebildet ist.

Vorteilhaft können frühzeitig Isolationsfehler oder andere Fehler, wie beispielsweise ungleichmäßige Temperaturprofile oder Lageschäden detektiert werden. Eindeutige Fehlermerkmale können erreicht werden oder alternativ auch eine Selbstüberprüfung der Messschaltung durchgeführt werden.

In einer technisch vorteilhaften Ausführungsform der Vorrichtung ist vorgesehen, dass die elektrische Verbindung als ein erster Kondensator und/oder ein erster und ein zweiter Kondensator ausgebildet ist, wobei der erste und der zweite Kondensator in Serie geschaltet sind, wobei der erste und/oder der zweite Kondensator als Y-Kondensator ausgebildet ist/sind, wobei insbesondere der erste Kondensator und der zweite Kondensator als ein gemeinsamer Spannungsteiler ausgebildet sind.

Vorteilhaft kann/können beispielsweise der erste und/oder der zweite Kondensator zur sicheren Trennung gegenüber dem Potential des Stators als Y-Kondensator ausgebildet sein. Vorteilhaft kann mittels Messung der Spannung und einer ersten Ableitung der Spannung an dem zweiten Kondensator direkt mittels einer zweiten Ableitung auf den Strom geschlossen werden. Weiterhin von Vorteil einer solchen Schaltung ist der Hochpasscharakter, da hierbei insbesondere Ströme im höherfrequenten Bereich mit einer besseren Auflösung gemessen werden können, während Ströme im niederfrequenten Bereich, wie beispielsweise 50Hz-Anteile, unterdrückt werden können.

Gemäß einem weiteren Aspekt wird die technische Aufgabe der Erfindung gelöst durch ein Verfahren zur Berechnung der verbleibenden Lebensdauer einer elektrischen Maschine mit einem Rotor und einem zu dem Rotor elektrisch isolierten Stator, umfassend eine Vorrichtung nach einem der vorangehenden Ansprüche, sowie umfassend die Verfahrensschritte:
a) Starten und Betreiben der elektrischen Maschine;
b) Messen eines ersten Phasenstroms eines Inverters zu der elektrischen Maschine mittels des ersten Sensors;
c) Messen eines zweiten Phasenstroms des Inverters zu der elektrischen Maschine mittels des zweiten Sensors;
d) Detektion einer Veränderung des elektrischen Signals, insbesondere eines Stroms und/oder eines Potentials, des Stators mittels des dritten Sensors;
e) Schreiben der Messdaten in einen, insbesondere nichtflüchtigen, Speicher, wobei bevorzugt eine mathematische Vorverarbeitung der Messdaten erfolgt;
f) Analyse der Messdaten auf Fehlerzustände in der elektrischen Maschine, insbesondere mittels einer mathematischen Funktion, bevorzugt mittels eines neuronalen Netzwerks.

Im Sinne der Erfindung ist unter dem Begriff eines Inverters eine Wechselrichterschaltung zu verstehen, die zur Erzeugung einer zum Betrieb der elektrischen Maschine gewünschten Stromform, beispielsweise mittels einer Pulsweitenmodulation (PWM), eine mit einem Pulsmuster beaufschlagte Spannung im zeitlichen Mittel an Klemmen der elektrischen Maschine anlegt. Im Sinne der Erfindung ist unter dem Begriff der Stromform die zeitliche Veränderung des Stroms zu verstehen.

Beispielsweise arbeitet der Inverter hierbei mit einer Schaltfrequenz außerhalb des hörbaren Bereichs, insbesondere mit mehr als 16 kHz. Auf Grund des geschalteten Pulsmuster ergibt sich am Ausgang des Inverters eine, gegenüber dem Erdpotential, mit der Schaltfrequenz des Inverters springende Gleichtaktspannung.

Vorteilhaft kann mittels des Verfahrens der unabhängigen und zusätzlichen Strommessung eine bessere Klassifizierung oder Erkennung etwaiger Fehler in der elektrischen Maschine erfolgen. Weiterhin ist von Vorteil, dass eine bessere Erkennung von Gleichtaktströmen und eine höhere Auflösung dieser erfolgen kann, da der Rückstrom über den Y-Kondensator bzw. der Strom über den Kontakt zum Stator nicht durch die drehmomentbildenden Motorströme überlagert ist.

Im Fall eines geerdeten Stators fließt beim Vorliegen eines Fehlers in der Isolation ein signifikanter Anteil des Stroms gegen Erde ab der mit Hilfe der Sensoren, beispielsweise mittels einer Summenbildung der Motorströme, ermittelt werden kann. Auf Grund der Frequenzeigenschaften des Kondensators, bei höheren Frequenzen eine niedrigere Impedanz darzustellen, können somit vorteilhaft hochfrequente Anteile des Stromes gemessen werden. Amplituden dieser hochfrequenten Anteile des Stroms können dabei zwar von der Einbaulage und den Erdungsbedingungen abhängen, dennoch weißt jede Erdung einen induktiven Anteil auf, der bei steigender Frequenz ebenfalls zu einer Verschiebung der Stromanteile hin zum Y-Kondensator beiträgt und mittels des Verfahrens vorteilhaft bestimmt werden kann.

Im Sinne der Erfindung ist unter einer mathematischen Vorverarbeitung eine Datenkompression, oder eine Datenverarbeitung zu verstehen.

Vorteilhaft kann mittels einer Vorverarbeitung der Messdaten die Datenmenge reduziert werden, oder bestimmte Kennwerte vorausberechnet werden.

In einer technisch vorteilhaften Ausführungsform des Verfahrens ist vorgesehen, dass die Detektion der Veränderung des elektrischen Potentials des Stators mittels einer Spannungsmessung über dem Kondensator, oder mittels einer Strommessung des Kondensatorstroms gemessen wird.

Beispielsweise kann zur Detektion der Veränderung des Potentials des Stators eine Kapazitätsveränderung des Stators oder ein Statorverschiebestrom gemessen werden. Im Sinne der Erfindung ist unter einem Verschiebestrom oder einem Verschiebungsstroms der Teil eines elektrischen Stroms zu verstehen, der durch die zeitliche Änderung des elektrischen Flusses gegeben ist.

Kommt es zu einem Fehler, beispielsweise zu einem Schaden in der Isolation der Wicklung, so führt dies zu einer Veränderung des Statorverschiebestroms und somit zu einer Veränderung der Kapazität zwischen dem Stator und dem festen Elektronikpotential bzw. Erdpotential. Mittels einer Anbindung des Stators über den Y-Kondensator lässt sich entweder mit Hilfe einer Messung der Spannung zwischen Kondensator und Stator oder mittels einer Strommessung des Stromes durch den Kondensator der hierdurch entstandene Fehler messtechnisch ermittelt werden.

In einer technisch vorteilhaften Ausführungsform umfasst das Verfahren den Verfahrensschritt
e1) Verarbeitung der Messdaten, insbesondere Aufteilung oder Zuteilung der Messdaten zu verschiedenen Frequenzbändern.

Beispielsweise kann die Verarbeitung oder die Aufteilung oder die Zuteilung der Messdaten mittels einer schnellen FourierTransformation oder einer Wavelet-Transformation erfolgen. Auch kann beispielsweise die Verarbeitung der Messdaten mittels einer mathematischen Funktion, oder mittels Integration, oder mittels Subtraktion oder mittels einer Filterung der Daten erfolgen. Weiterhin kann beispielsweise die Verarbeitung der Messdaten mittels einer künstlichen Intelligenz oder mittels Techniken des maschinellen Lernens, insbesondere mittels neuronaler Netze, genetischer Algorithmen, Support Vector Machines, k-Means, Kernel-Regression oder Diskriminanzanalyse, erfolgen, wobei beispielsweise basierend auf Rechenmodellen und Algorithmen zur Klassifizierung, Bündelung, Regression ein sogenannter erster Trainings-Datensatz erzeugt werden kann.

Vorteilhaft können so Eigenschaften berechnet werden, die einem möglichen Fehler in der Isolation des Stators, oder möglichen Lagerschäden, oder einer fehlerhaften Temperatur der elektrischen Maschine zugeordnet werden können.

In einer weiteren technisch vorteilhaften Ausführungsform ist vorgesehen, dass eine Selbstüberprüfung durchgeführt wird, wobei insbesondere der erste Phasenstrom und der zweite Phasenstrom und der Rückstrom gleichzeitig gemessen wird, diese drei Ströme in ein Verhältnis zueinander gesetzt werden.

Vorteilhaft können so Eigenschaften eines möglichen Fehlers der elektrischen Maschine besser und eindeutiger identifiziert werden.

In einer weiteren technisch vorteilhaften Ausführungsform ist vorgesehen, dass mittels der drei Sensoren eine Regelung des Betriebs der elektrischen Maschine stattfindet.

Vorteilhaft können beispielsweise mittels einer Kombination der in der Regelung, und/oder auf dem Printed Circuit Board (PCB) vorhandenen Parameter und Signalen, wie beispielsweise Lagewinkel, Duty-Cycle oder Zwischenkreisspannung eine zusätzliche Erkennung von Eigenschaften möglicher Fehler der elektrischen Maschine ermöglicht werden und somit nichtnormale Zustände der elektrischen Maschine sicher erkannt werden.]

In einer weiteren technisch vorteilhaften Ausführungsform des Verfahrens ist vorgesehen, dass es zum Betrieb der Vorrichtung nach einem der vorangehenden Ansprüche 1 oder 2 ausgebildet ist.

Ein Ausführungsbeispiel der Erfindung ist in der Figur dargestellt und wird im Folgenden näher beschrieben.

Es zeigt:

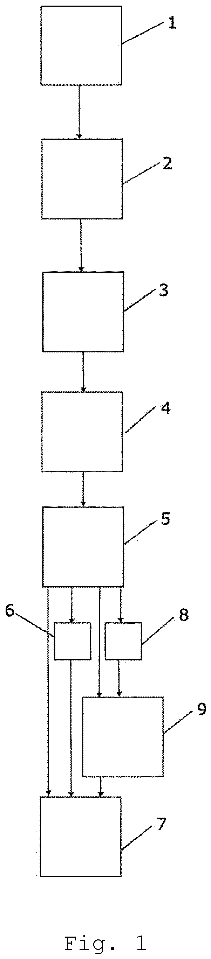

- Figur 1: eine schematische Darstellung des Verfahrens.

In Figur 1 ist schematisch ein Verfahren zur Berechnung der verbleibenden Lebensdauer einer elektrischen Maschine mit einem Rotor und einem zu dem Rotor elektrisch isolierten Stator, umfassend eine Vorrichtung nach einem der vorangehenden Ansprüche, sowie umfassend die folgenden Verfahrensschritte dargestellt:
a) Starten und Betreiben der elektrischen Maschine 1;
b) Messen eines ersten Phasenstroms eines Inverters zu der elektrischen Maschine mittels des ersten Sensors 2;
c) Messen eines zweiten Phasenstroms des Inverters zu der elektrischen Maschine mittels des zweiten Sensors 3;
d) Detektion einer Veränderung des elektrischen Signals 4, insbesondere eines Stroms und/oder eines Potentials, des Stators mittels des dritten Sensors;
e) Schreiben der Messdaten in einen, insbesondere nichtflüchtigen, Speicher 5, wobei bevorzugt eine mathematische Vorverarbeitung der Messdaten 6 erfolgt;
f) Analyse der Messdaten auf Fehlerzustände in der elektrischen Maschine 7, insbesondere mittels einer mathematischen Funktion, bevorzugt mittels eines neuronalen Netzwerks.

Weiterhin ist in Figur 1 ein Verfahrensschritt
e1) Verarbeitung der Messdaten 8, insbesondere Aufteilung oder Zuteilung der Messdaten zu verschiedenen Frequenzbändern 9
dargestellt.

Details zu den einzelnen Verfahrensschritten sind im oben genannten allgemeinen Teil der Beschreibung der Erfindung beschrieben. Auf diesen wird auch für das Ausführungsbeispiel unmittelbar und vollständig Bezug genommen und zum Gegenstand des Ausführungsbeispiels gemacht.

Das Verfahren gemäß der Erfindung kann einzeln, oder als Schleife, insbesondere als periodische Schleife oder über ein Triggerereignis, beispielsweise ein Kontrollereignis ausgelöst werden.

### Bezugszeichen

- 1: Starten und Betreiben der elektrischen Maschine
- 2: Messen eines ersten Phasenstroms
- 3: Messen eines zweiten Phasenstroms
- 4: Detektion einer Veränderung des elektrischen Signals
- 5: Schreiben der Messdaten in einen Speicher
- 6: Vorverarbeitung der Messdaten
- 7: Analyse der Messdaten auf Fehlerzustände
- 8: Verarbeitung der Messdaten
- 9: Aufteilung oder Zuteilung der Messdaten zu verschiedenen Frequenzbändern

## Patentansprüche

1. Vorrichtung zur Detektion von Fehlerzuständen in einer elektrischen Maschine mit einem Rotor und einem zu dem Rotor elektrisch isoliert aufgebauten Stator, umfassend eine Anschlusselektronik zum Anschluss der elektrischen Maschine,
wobei entweder der Stator mittels einer elektrischen Verbindung an einem gegenüber dem Erdpotential stabilen ersten elektrischen Potential der Anschlusselektronik verbunden ist,
oder der Stator direkt mit einem, gegenüber dem Erdpotential, stabilen zweiten elektrischen Potential verbunden ist und das zweite elektrische Potential mittels der elektrischen Verbindung mit der Anschlusselektronik verbunden ist,
**dadurch gekennzeichnet, dass**
ein erster Sensor zur Messung eines ersten Phasenstroms, sowie ein zweiter Sensor zur Messung eines zweiten Phasenstroms, sowie ein dritter Sensor zur Messung eines elektrischen Signals des Stators über und/oder an der elektrischen Verbindung ausgebildet ist.

2. Vorrichtung nach Anspruch 1 **dadurch gekennzeichnet, dass** die elektrische Verbindung als ein erster Kondensator und/oder ein erster und ein zweiter Kondensator ausgebildet ist,
wobei der erste und der zweite Kondensator in Serie geschaltet sind,
wobei der erste und/oder der zweite Kondensator als Y-Kondensatorausgebildet ist/sind,
wobei insbesondere der erste Kondensator und der zweite Kondensator als ein gemeinsamer Spannungsteiler ausgebildet sind.

3. Verfahren zur Berechnung der verbleibenden Lebensdauer einer elektrischen Maschine mit einem Rotor und einem zu dem Rotor elektrisch isolierten Stator,
umfassend eine Vorrichtung nach einem der vorangehenden Ansprüche,
sowie umfassend die Verfahrensschritte:
a) Starten und Betreiben der elektrischen Maschine (1);
b) Messen eines ersten Phasenstroms eines Inverters zu der elektrischen Maschine mittels des ersten Sensors (2);
c) Messen eines zweiten Phasenstroms des Inverters zu der elektrischen Maschine mittels des zweiten Sensors (3);
d) Detektion einer Veränderung des elektrischen Signals (4), insbesondere eines Stroms und/oder eines Potentials, des Stators mittels des dritten Sensors;
e) Schreiben der Messdaten in einen, insbesondere nichtflüchtigen, Speicher (5), wobei bevorzugt eine mathematische Vorverarbeitung der Messdaten (6) erfolgt;
f) Analyse der Messdaten auf Fehlerzustände in der elektrischen Maschine (7), insbesondere mittels einer mathematischen Funktion, bevorzugt mittels eines neuronalen Netzwerks.

4. Verfahren nach Anspruch 3, **dadurch gekennzeichnet, dass** die Detektion der Veränderung des elektrischen Potentials des Stators mittels einer Spannungsmessung über dem Kondensator, oder mittels einer Strommessung des Kondensatorstroms gemessen wird.

5. Verfahren nach einem der vorangehenden Ansprüche 3 oder 4, umfassend den Verfahrensschritt
e1) Verarbeitung der Messdaten (8), insbesondere Aufteilung oder Zuteilung der Messdaten zu verschiedenen Frequenzbändern (9).

6. Verfahren nach einem der vorangehenden Ansprüche 3 bis 5, **dadurch gekennzeichnet, dass** eine Selbstüberprüfung durchgeführt wird, wobei insbesondere der erste Phasenstrom und der zweite Phasenstrom und der Rückstrom gleichzeitig gemessen wird, diese drei Ströme in ein Verhältnis zueinander gesetzt werden.

7. Verfahren nach einem der vorangehenden Ansprüche 3 bis 6, **dadurch gekennzeichnet, dass** mittels der drei Sensoren eine Regelung des Betriebs der elektrischen Maschine stattfindet.

8. Verfahren nach einem der vorangehenden Ansprüche **dadurch gekennzeichnet, dass** es zum Betrieb der Vorrichtung nach einem der vorangehenden Ansprüche 1 oder 2 ausgebildet ist.
